# EUROPEAN PATENT APPLICATION

(11) **EP 4 654 759 A1**
(43) Date of publication of application: **26.11.2025**
(21) Application number: 25175069.1
(22) Date of filing: 08.05.2025
(51) Int. Cl.: H05K 3/28, H05K 1/18, H05K 1/14

(54) **BARRIERS IN SEMICONDUCTOR DEVICES**

(30) Priority: 24.05.2024 US 202418674027
(71) Applicant: Avago Technologies International Sales Pte. Limited, Singapore 768923 (SG)
(72) Inventor: Mayukh, Mayank, Fort Collins, CO 80525 (US); Gallegos, Adam Eugene, Fort Collins, CO 80524 (US); Tendel, Shrikara Prabhu, 730726 Singapore (SG); Pallinti, Jayanthi, Los Gatos, CA 95030 (US); Dix, Gregory, Fort Collins, CO 80528 (US); Tsau, Liming, Irvine, CA 92620 (US)
(74) Representative: Grünecker Patent- und Rechtsanwälte PartG mbB

(57) **Abstract**

Novel tools and techniques are provided for implementing a semiconductor package or a chip package, and more particularly methods, systems, and apparatuses are provided for implementing a semiconductor package or a chip package including one or more barriers to form a keep-out-zone or a keep-in-zone. In various embodiments, system include a substrate including a first layer, a wall coupled to a first surface of the first layer, and a material coupled to the first surface of the first layer. The wall can be configured to block the material from flowing or expanding outside of the wall.

## Description

### COPYRIGHT STATEMENT

A portion of the disclosure of this patent document contains material that is subject to copyright protection. The copyright owner has no objection to the facsimile reproduction by anyone of the patent document or the patent disclosure as it appears in the Patent and Trademark Office patent file or records, but otherwise reserves all copyright rights whatsoever.

### FIELD

The present disclosure relates, in general, to methods, systems, and apparatuses for implementing a semiconductor package or a chip package.

### BACKGROUND

In existing semiconductor devices, keep-out-zones (KOZs) are used to prevent one element of a semiconductor device from encroaching on or spreading to another element of the semiconductor device. In non-limiting examples, KOZs can be used to prevent underfill materials, adhesive materials, thermal interface materials, or the like from flowing or leaking outside of the KOZ. However, as semiconductor packaging becomes more complex and functionality increases, there is a need for containing these materials within narrow or small boundaries.

Hence, there is a need for more robust and scalable solutions for implementing semiconductor packages and chip packages. Thus, methods, systems, and apparatuses are provided for implementing semiconductor packages or chip packages including a barrier for forming a KOZ.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
FIG. 1 is a schematic cross-sectional view of a semiconductor device comprising one or more embedded barriers, in accordance with various embodiments;
FIG. 2 is a cross-sectional view of a portion of the semiconductor device of FIG. 1, in accordance with various embodiments;
FIG. 3 is a perspective view of one or more first layers of the first substrate comprising one or more walls of the semiconductor device of FIG. 1, in accordance with various embodiments;
FIG. 4 is a perspective view of one or more first layers of the first substrate comprising one or more walls and a die of the semiconductor device of FIG. 1, in accordance with various embodiments;
FIG. 5 is a schematic cross-sectional view of another semiconductor device comprising one or more barriers, in accordance with various embodiments;
FIG. 6 is a perspective view of yet another semiconductor device comprising one or more barriers, in accordance with various embodiments;
FIG. 7 is a top view of yet another semiconductor device comprising one or more barriers, in accordance with various embodiments;
FIG. 8 is a top view of yet another semiconductor device comprising one or more barriers, in accordance with various embodiments;
FIG. 9 is a flow diagram of a method of manufacturing the barrier formed on a first surface of a substrate, in accordance with various embodiments;
FIG. 10 is a flow diagram of a method of manufacturing the barrier formed between two substrates, in accordance with various embodiments;
FIGS. 11A-11D are cross-sectional views of the steps to manufacture a semiconductor device using the method of FIG. 10, in accordance with various embodiments;
FIG. 12 is a flow diagram of a method of manufacturing a barrier embedded within a substrate, in accordance with various embodiments; and
FIGS. 13A-13E are cross-sectional views the steps to manufacture a semiconductor device using the method of FIG. 12, in accordance with various embodiments.

### DETAILED DESCRIPTION OF EMBODIMENTS

Various embodiments provide tools and techniques for implementing semiconductor packages or chip packages including a barrier for forming a keep-out-zone are described herein.

In a first aspect, a semiconductor device can include a first substrate comprising a first layer, a wall coupled to a first surface of the first layer, and a material coupled to the first surface of the first layer, wherein the wall is configured to block the material from flowing outside of the wall. In various cases, the wall comprises a perimeter formed using two or more layers of printed material or jetted material, and the perimeter of the wall can be configured to contain the material and to block the material from flowing outside of the wall. The perimeter of the wall can be at least one of circle-shaped, oval-shaped, triangle-shaped, square-shaped, or rectangular-shaped.

In some cases, a height of the wall is about 10 micrometers to 50 micrometers, and a width of the of the wall is about 10 micrometers to 50 micrometers. In some cases, the wall is formed from at least one of an oligomer, a polymer, an ink-based material, an emulsion-based material, or an inorganic material, or a combination of one or more the oligomer, the polymer, the ink-based material, the emulsion-based material, or the inorganic into a sol, a gel, a pigment, a paste, or a solution.

In various cases, the semiconductor device further includes a die coupled to the surface of the first layer via a connector. In some cases, the wall is located between the first surface of the first layer and a second surface of the die and the material coupled to the first layer is located between the first surface of the first layer and the second surface of the die. In some cases, a first ratio of a first height of the wall to a first width of the wall is between about 1:2 and about 1:5. In various cases, the wall is formed from a conductive material and is configured to be coupled to a connector of at least one of the first substrate or the die. In some instances, the first substrate further comprises a second layer coupled to the first substrate, and the die can be at least partially embedded within a second layer of the first substrate. The wall comprises a perimeter formed using two or more layers of printed material or jetted material, and the perimeter of the wall can be located under an edge of the die and can be configured to contain the material and to block the material from flowing outside of the wall. In some cases, a second ratio of a first height of the wall to a second height of the first substrate is between about 1:5 and about 1:2,

In some embodiments, the semiconductor device further includes a second substrate coupled to the first surface of the first layer via a connector. In this case, the wall can be located between the first surface of the first layer and a second surface of the second substrate and the material coupled to the first layer can be located between the first surface of the first layer and a third surface of the second substrate. The wall comprises a perimeter formed using two or more layers of printed material or jetted material, and the perimeter of the wall can be configured to contain the material and to block the material from flowing outside of the wall.

In some cases, the wall can be formed from at least one of two or more layers of a printed material or two or more layers of a jetted material.

Another aspect can include a method of manufacturing one or more walls configured to block flow of material from a selected location. The method can include forming a first layer of a first substrate, forming a wall on a first surface of the first substrate, and coupling a material to the first surface of the first substrate. In some cases, the wall is configured to block the material from flowing outside of the wall.

In various embodiments, the wall can be formed using at least one of extrusion or jetting to form two or more layers and the wall can be formed from at least one of an oligomer, a polymer, an ink-based material, an emulsion-based material, or an inorganic material, or a combination of one or more the oligomer, the polymer, the ink-based material, the emulsion-based material, or the inorganic into a sol, a gel, a pigment, a paste, or a solution.

In various cases, forming the first layer can include forming an interconnect in the first layer and the method can further include coupling a die to the first surface of the first substrate. In some instances, a connector of the die is connected to the interconnect and coupling a material to the first surface of the first substrate comprises inserting the material between the die and the first surface to surround the connector.

In some embodiments, the wall comprises a perimeter and an internal area of the perimeter of the wall can be configured to contain the material within the internal area of the perimeter of the wall. The method can further include forming a second layer on the first surface of the substrate and the die, wall, and material can be at least partially embedded within the second layer.

In yet another aspect, a method can include a first substrate comprising a first layer, a wall coupled to a first surface of the first layer, a material coupled to the first surface of the first layer, and a die or a second substrate coupled to the first layer. In some embodiments, the wall is configured to block the material from flowing outside of the wall and the wall and material are located between the first surface of the first layer and a second surface of the die or second substrate.

In the following description, for the purposes of explanation, numerous details are set forth to provide a thorough understanding of the described embodiments. It will be apparent to one skilled in the art, however, that other embodiments may be practiced without some of these details. Several embodiments are described herein, and while various features are ascribed to different embodiments, it should be appreciated that the features described with respect to one embodiment may be incorporated with other embodiments as well. By the same token, however, no single feature or features of any described embodiment should be considered essential to every embodiment of the invention, as other embodiments of the invention may omit such features.

When an element is referred to herein as being "connected," "coupled," or "attached" to another element (such as coupled or connected through an electrical or communicative connection or coupled or attached through a mechanical connection or attachment), it is to be understood that the elements can be directly connected to the other element, or have intervening elements present between the elements. In contrast, when an element is referred to as being "directly connected," "directly coupled," or "directly attached" to another element, it should be understood that no intervening elements are present in the "direct" connection between the elements. However, the existence of a direct connection does not exclude other connections or contacts, in which intervening elements may be present.

When an element is referred to herein as being "disposed" or "located" in some manner relative to another element (e.g., disposed on, disposed between, disposed under, disposed adjacent to, or disposed in some other relative manner), it is to be understood that the elements can be directly disposed or located relative to the other element (e.g., disposed directly on another element), or have intervening elements present between the elements. In contrast, when an element is referred to as being "disposed directly" or "located directly" relative to another element, it should be understood that no intervening elements are present in the "direct" example. However, the existence of a direct disposition does not exclude other examples in which intervening elements may be present.

Likewise, when an element is referred to herein as being a "layer," it is to be understood that the layer can be a single layer or include multiple layers. For example, a conductive layer may comprise multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Additionally, when an element is referred to herein as being a "circuit" or "die", it is commonly recognized as a building block of modern electronics. Circuits or dies are composed of various electronic components such as resistors, capacitors, inductors, diodes, transistors, and integrated circuits. In some cases, integrated circuits can be formed from one or more circuits. These electronic components are carefully selected and interconnected to create a circuit that can perform a specific task or carry out a particular function. Circuits can be as simple as a basic switch that turns a light on and off, or they can be incredibly complex, such as those found in advanced computer systems, communication devices, or medical equipment. Circuits can be categorized into different types based on their purpose or function, including amplifiers, oscillators, filters, power supplies, and logic gates, among others. Additionally, circuits can include software or firmware in addition to hardware or instead of hardware to carry out a particular function.

Additionally, various units, circuits, modules, or other components may be described as "configured to" or "adapted to" perform a task or tasks. In such contexts, "configured to" or "adapted to" is a broad recitation of structure generally meaning "having circuitry that" performs the task or tasks during operation. As such, the unit/circuit/module/component can be configured to perform the task even when the unit/circuit/module/component is not currently on. In general, the circuitry that forms the structure corresponding to "configured to" or "adapted to" may include hardware circuits and/or memory storing program instructions executable to implement the operation. The memory can include volatile memory such as static or dynamic random-access memory and/or nonvolatile memory such as optical or magnetic disk storage, flash memory, programmable read-only memories, etc. Similarly, various unit/circuit/module/component may be described as performing a task or tasks, for convenience in the description. Such descriptions should be interpreted as including the phrase "configured to" or "adapted to." Reciting a unit/circuit/component that is configured to perform one or more tasks is expressly intended not to invoke 35 U.S.C. §112, paragraph six interpretation for that unit/circuit/component.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components. Additionally, terms such as first, second, third, are merely used to distinguish elements or components from each other and are not intended to imply an order, sequence or amount unless expressly stated otherwise.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." The term "substantially" or "about" used herein refers to variations from the reference value or ratio of ± 20% or less (e.g., ± 20%, ± 10%, ± 5%, etc.), inclusive of the endpoints of the range.

In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

In existing semiconductor or chip packages, keep-out-zones (KOZs) are typically used to prevent elements or materials of a semiconductor device from encroaching or spreading to other elements or components of the semiconductor device. Typically, KOZs can be passive relying on inherent properties of the material to contain the spread of the material. However, in these cases, the materials typically spread over a larger area requiring a larger KOZ. Larger KOZs can take away areas of the semiconductor package that could otherwise be used to increase or improve the functionality of the semiconductor package.

The subject technology comprises a semiconductor or chip device (e.g., integrated circuit (IC), chip, or other semiconductor device or module) that provides a barrier to form a KOZ. The barrier can be formed by one or more walls configured to prevent the spread of the material outside of the barrier into the KOZ. In other words, the barrier can be used to form a keep-in-zone (KIZ) that prevents one or more materials from spreading outside of the barrier into the KOZ. The barrier can be made from small molecules, oligomers, polymers, or inorganic materials, or their combination in a sol, gel, colloidal solutions, pigment, paste, solution formulation. The barrier material can further be formed from an electrically insulating material, a thermally conducting material, or a low surface energy material, or the like. The barrier can be pre-formed and applied using pick-and-place tools or formed using jetting techniques, extrusion-based techniques, or similar processes.

By forming a barrier to prevent the spread of material contained within the barrier, several advantages can be realized. For example, by using the barrier, the KOZ can be smaller which can provide more area to be used to increase or improve the functionality of the semiconductor package. Additionally, barrier materials can be cured *in situ* using ultra-violet lights or heat.

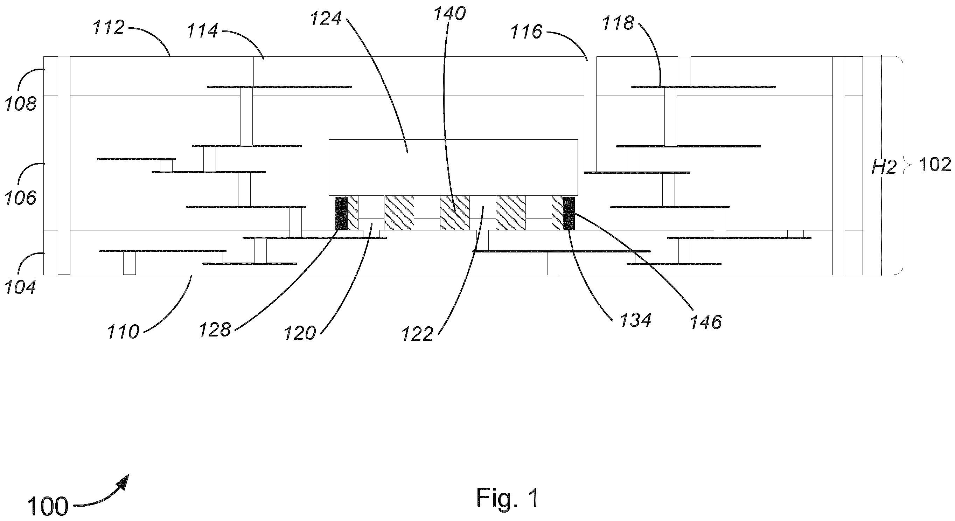

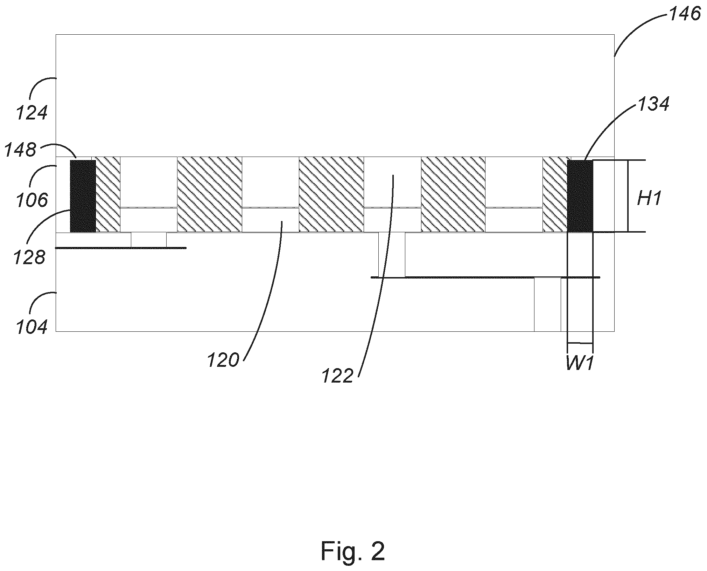

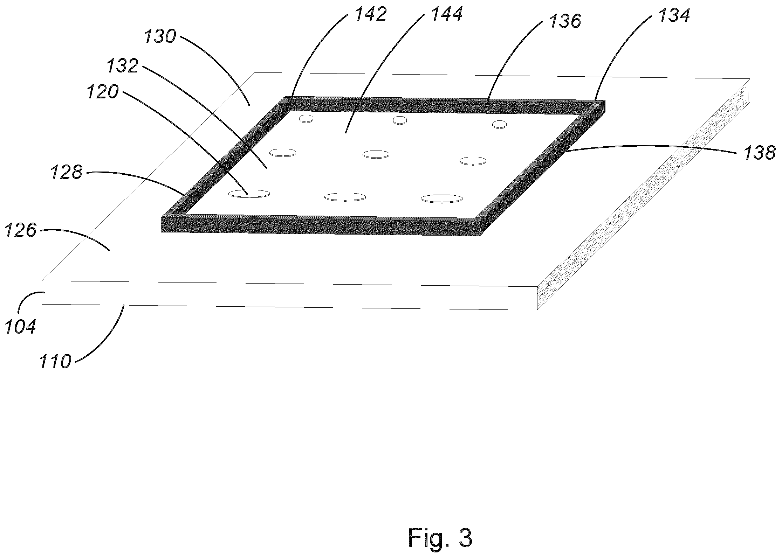

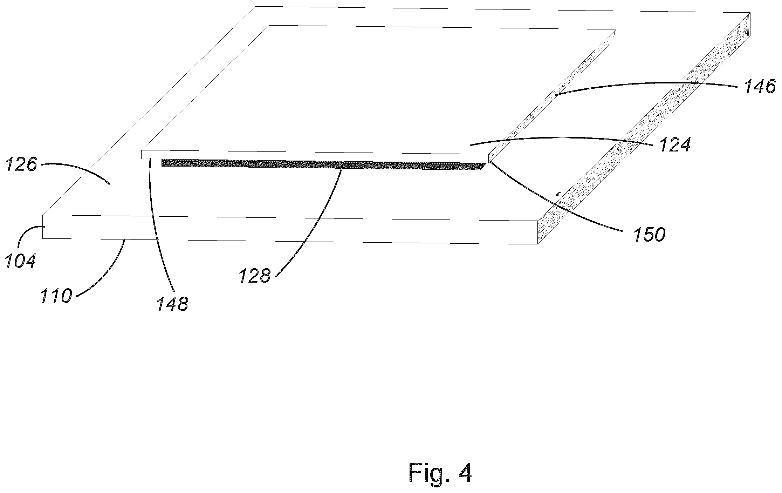

FIGS. 1-4 are schematic views of a first embodiment of a semiconductor device 100. FIG. 1 is a schematic cross-sectional view of a semiconductor device 100 comprising one or more embedded barriers 128. FIG. 2 is a cross-sectional view of a portion of the semiconductor device 100 of FIG. 1. FIG. 3 is a perspective view of one or more first layers 104 of the first substrate 102 comprising one or more barriers 128 coupled to a first surface 110 of the first substrate 102. FIG. 4 is a perspective view of one or more first layers 104 of the first substrate 102 comprising one or more barriers 128 coupled to a first surface 110 of the first substrate 102 and having a die 124 coupled to the first substrate 102.

It should be noted that the various components of semiconductor device 100 are schematically illustrated in FIGS. 1-4, and that modifications to the various components, orientations, and other arrangements of semiconductor device 100 may be possible and in accordance with the various embodiments. In addition, only some components and/or layers of the semiconductor device 100 are shown in FIGS. 1-4, there could be more or less components and/or layers, in accordance with various embodiments and semiconductor device 100 is not intended to be limited to only the components and/or layers shown. In addition, although Figs. 1-8 are described as separate embodiments for ease of description, a person of ordinary skill would understand that various modifications to each embodiment may be applied to other embodiments.

Turning to the embodiment of FIGS. 1-4, the semiconductor device 100 can include a first substrate 102 or interposer. The first substrate 102 can include a supporting material (e.g., silicon, and/or any other semiconductor material or combination of materials) upon which or within which elements or components (e.g., connectors, passive devices, active devices, or the like) of semiconductor device 100 are fabricated or coupled. In some cases, the first substrate 105 can be an interposer (e.g., a substrate or layer configured to provide one or more connections or interconnections (e.g., electrical connections, or the like)) between two other substrates or semiconductor components (not shown). When the first substrate 102 is an interposer, the first substrate 102 can still include one or more passive devices, active devices, or other components, or the like. The one or more passive devices can be one or more circuit components (e.g., conductors, resistors, capacitors, inductors, etc.) which can transmit, absorb, and/or dissipate power. The one or more active devices can be one or more circuit components (e.g., transistors, or the like) that can control the flow of power.

In various cases, the first substrate 102 can be formed from one or more layers. The one or more layers can include, without limitation, one or more dielectric layers, one or more device layers, one or more conducting layers, one or more insulating layers, one or more redistribution layers, and/or the like. The one or more layers can include one or more first layers 104, one or more second layers 106, one or more third layers 108, or one or more other layers.

In various cases, the one or more first layers 104 can be one or more first outer layers (e.g., one or more layers comprising a first outer surface 110 of the first substrate 102) of the first substrate 102. In various cases, the one or more third layers 108 can be one or more second outer layers (e.g., one or more layers comprising a second outer surface 112 of the first substrate 102) of the first substrate 102. In some instances, the outer surface 110 or 112 of the first substrate 102 can be configured to couple to another substrate such as a circuit board (e.g., a printed circuit board or the like), a die, another substrate, or the like.

In some instances, the one or more first layers 104, one or more second layers 106, one or more third layers 108 or the like can include one or more interconnects 114. The one or more interconnects 114 can include, without limitation, one or more of one or more vias 116, one or more wires or lines 118, one or more pads or connectors 120, one or more planes, one or more conductive films or coatings, one or more solder welds, one or more solder balls or bumps, or one or more other interconnects or connectors, or the like. The one or more interconnects 114 can be formed from an electrically conductive material such as copper, tungsten, aluminum, gold, silver, tin, nickel, lead, or a combination of metals/alloys, or may be formed of other electrically conductive material or combination of electrically conductive materials.

The one or more interconnects 114 can be directly or indirectly connected (e.g., electrically connected) or directly or indirectly coupled (e.g., attached) to one or more interconnects or connectors 122 of a die 124, circuit, or other active or passive components at least partially, substantially, or fully embedded within the one or more second layers 106 or to one or more other connectors or interconnects of another substrate (not shown). The one or more connectors 122 can be similar to the one or more interconnects 114. In some cases, the one or more interconnects 114 can be coupled to the one or more connectors 122 using one or more pads 120, one or more conductive films or coatings, one or more solder welds, one or more solder balls or bumps, or the like located on an inner surface 126 (e.g., a surface located between the one or more first layers 104 and the one or more second layers 106) of the one or more first layers 104.

The one or more dies 124, circuits, or other active or passive components can include, without limitation, one or more electronic dies, one or more electronic circuits, one or more electronic integrated circuits (EICs), one or more photonic dies, one or more photonic circuits, one or more photonic integrated circuits (PICs), one or more active devices, one or more passive devices, or other components or the like. The one or more dies 124 can include one or more layers (not shown). The one or more layers can include, without limitation, one or more dielectric layers, one or more device or circuit layers, one or more conducting layers, one or more insulating layers, one or more redistribution layers, other layers, and/or the like. The layers may further include one or more layers configured to provide component interconnections. In some embodiments, the one or more dies 124 can include, without limitation, a processing circuit (e.g., a central processing unit, a microprocessor, or the like), a switch circuit (e.g., a switch application specific integrated circuit (ASIC) or the like), an input/output circuit, a memory circuit, a circuit configured to receive one or more optical signals, a voltage regulator, a capacitor, passive wires, or the like.

In various cases, the semiconductor device 100 can further include one or more barriers 128 configured to form a KOZ 130 and a KIZ 132 as shown in FIGS. 3 and 4. The one or more barriers 128 can be coupled to or formed on the inner surface 126 of the one or more first layers 104 or one or more other layers of the first substrate 102. The one or more barriers 128 can include one or more walls 134. In some cases, an inner surface 136 of the one or more walls 134 can form the KIZ 132 while an outer surface 138 of the one or more walls 134 can form the KOZ 130. Alternatively, in other cases, the outer surface 138 of the one or more walls 134 can form the KIZ while the inner surface 136 of the one or more walls 134 can form the KOZ (not shown).

In various instances, the one or more walls 134 can be configured to at least partially, substantially, or fully contain a material 140 (shown by the patterned or lined area within the one or more walls 134 of FIG. 1) within the KIZ 132 and at least partially, substantially, or fully block or prevent the material 140 from flowing outside of the KIZ 132 into the KOZ 130. The material 140 can include, without limitation, at least one of an underfill material, an adhesive material, or a thermal interface material, or any other material configured to be contained within the KIZ 132.

In a non-limiting example, the one or more underfill materials can include, without limitation, one or more one or more polymer materials in the form of epoxy materials or other materials or combinations of materials configured to insulate the one or more interconnects 114 or the connectors 122. In a non-limiting example, the one or more adhesive materials can include, without limitation, one or more polymer materials in the form of one or more glues, one or more pastes, or other material or combination of materials configured to hold or adhere one or more materials or components of the semiconductor device 100 together. In another non-limiting example, the one or more thermal interface materials can include, without limitation, gallium, indium, tin, solder, liquid metal, polymer, or other thermal interface material, or combination of thermal interface materials configured to thermally conduct heat between one or more components of the semiconductor device 100. The one or more materials 140 could further be contained within at least one of a paste, an adhesive, a gel, a solution, a film, or the like.

In some embodiments, the one or more walls 134 can be used to form a perimeter 142 configured to at least partially, substantially, or fully surround the one or more materials 140. The perimeter 142 can be at least one of circle-shaped, oval-shaped, triangle-shaped, square-shaped, or rectangular-shaped, or any other shape or structure comprising an outer perimeter 142 surrounding an internal area 144. The internal area 144 can be used to form the KIZ 132. Alternatively, the internal area 144 can be used to form the KOZ 130 (not shown). In some cases, the one or more walls 134 or the perimeter 142 can have substantially a uniform height.

In various instances, the one or more walls 134 can be pre-formed and applied using pick-and-place techniques or tools or formed *in situ* using at least one of jetting techniques, extrusion techniques, or other techniques. In various cases, the one or more walls 134 can be performed (e.g., using one or more jetting techniques, extrusion techniques, or the like) and then applied or coupled using modern pick-and-place techniques to the inner surface 126 of the one or more first layers 104.

In some cases, jetting techniques similar to ink printing, inkjet printing, emulsion-based printing, or the like, can be used to deposit one or more barrier materials (e.g., ink-based materials, emulsion-based materials, or other materials) for the one or more walls 134 onto the inner surface 126 of the one or more first layers 104. In various cases, the one or more barrier materials for the one or more walls 134 can be deposited onto the inner surface 126 of the one or more first layers 104 using a pressurized continuous stream of barrier material, by depositing the barrier material one drop at a time, or using another method, or the like. One or more layers of barrier material can be deposited on the inner surface 126 of the one or more first layers 104 to build the one or walls 134. In other words, the one or more walls 134 can be formed by sequentially depositing one or more layers of barrier material on top of each other until a desired wall height is obtained. In some cases, a first barrier can be formed and then another barrier can be stacked on top of the first barrier. In various cases, the one or more barrier materials for the one or more walls 134 can be cured *in situ* using an ultra-violet light, or the like.

In other cases, extrusion processes or techniques such as 3D printing techniques can be used to extrude or 3D print the one or more walls 134. One or more layers of material (e.g., polymer-based material or other material) can be deposited on the inner surface 126 of the one or more first layers 104 to build the one or walls 134. In other words, the one or more walls can be formed by sequentially depositing one or more layers of barrier material or on top of each other until a desired wall height is obtained. In some cases, a first barrier can be formed and then another barrier can be stacked on top of the first barrier. In various cases, the one or more barrier materials used to form the one or more walls 134 can be cured thermally as the one or more layers are deposited or extruded. In some cases, the one or more barrier materials can be preformed and applied to the device using modem pick-and-place techniques or created using extrusion based techniques to form the one or more walls 134.

In various cases, the one or more barrier materials that can be used for the one or more walls 134 can include, without limitation, one or more small molecules, one or more organic materials, one or more oligomers, one or more polymers, one or more inorganic materials, one or more ink-based materials, one or more emulsion-based materials, or one or more other materials, or a combination of one or more the one or more small molecules, one or more oligomers, one or more polymers, one or more inorganic materials, one or more ink-based materials, or one or more emulsion-based materials into a sol, a gel, a pigment, a paste, or a solution, or the like. In some cases, the one or more walls 134 can be formed from an electrically conductive material such as an electrically conductive ink-based material, emulsion-based material, polymer, oligomer, polymer inorganic material, or other material. In this case, the one or more walls 134 can further be used as one or more interconnects 114 within the first substrate 102 or connectors 122 for the die 124. In some cases, the one or more walls 134 can be jetted or extruded using one or more materials (e.g., one or more silicone-based or other polymer-based materials) that are deformable or flexible after the one or more materials are cured or set. By using one or more deformable materials within the substrate 102, the one or more barriers 128 can be configured to deform or deflect under pressure and are less likely to fracture or break. Further, by using one or more deformable materials within the substrate 102, the one or more barriers 128 can be configured to act like a gasket or deform or deflect to create a seal between one or more layers of the substrate 102. In some cases, as discussed above, the one or more walls 134 can be formed from one or more layers sequentially deposited on top of preceding layer until a desired wall height is obtained.

In some embodiments, one or more dimensions of the one or more barriers 128 or walls 134 can be controlled or associated with one or more dimensions or features of a nozzle of the jetting device, extrusion device, 3D printer, or the like. In a non-limiting example, a width or diameter of the nozzle can be configured to control a width (W1) of the one or more walls 134. For example, a width (W1) of the one or more walls 134 could be less than or about equal to a width or diameter of the nozzle.

In some instances, a first height (H1) shown in FIG. 2 of the one or more walls 134 can be about 10 micrometers to about 100 micrometers. Preferably, the first height (H1) of the one or more walls 134 can be about 20 micrometers to about 50 micrometers. The first height (H1) of the one or more walls 134 can be so small because of the one or more materials and techniques that are used to form the one or more walls. In a non-limiting example, by applying preformed barriers or forming barriers using jetting or extrusion techniques on the inner surface 126 of the one or more first layers 104, the first height (H1) of the one or more walls 134 can be about 20 micrometers to about 50 micrometers and, therefore, take up less space within the first substrate 102. By forming one or more walls 134 that take up less space, functionality can be improved or increased within the substrate 102. For example, more dies 124 could be embedded within the substrate 102, more interconnects 114 can be formed within the substrate 102, or more passive or active devices can be formed within the substrate 102, or the like.

In various cases, a width (W1) of the one or more walls 134 could be about 10 micrometers to 100 micrometers. In some cases, a first ratio of the first height (H1) to the first width (W1) for jetting one or more ink-based materials or emulsion-based material can be about 1:1 to about 5:1 or higher. In some cases, a first ratio of the first height (H1) to the first width (W1) for extruding or 3D printing one or more polymer materials or the like can be about 1:1 to about 10:1 or higher.

In various cases, a second height (H2) shown in FIG. 1 of the substrate 102 could be about 100 micrometers or less. A second ratio of the first height (H1) of the one or more walls 134 to the second height (H2) of the substrate 102 could be between about 1:10 to about 1:2. As discussed above, because the first height (H1) of the one or more barriers 128 is so much less than the second height (H2) of the first substrate 102, the one or more walls 134 can take up less space within the first substrate 102 and functionality can be improved or increased within the first substrate 102.

In the embodiments shown in FIGS. 1-4, the one or more barriers 128 can be coupled to the inner surface 126 of the one or more first layers 104 and at least partially, substantially, or fully embedded within the one or more second layers 106. The one or more barriers 128 can be used to form a KIZ 132 underneath the die 124 and a KOZ 130 towards one or more edges 146 of the die 124 (shown in FIGS. 1-4) or just outside of the one or more edges 146 of the die 124 (not shown). In some cases, a shape of the perimeter 142 can mirror or be about the same as a shape of the die 124. In some instances, a width or length of the perimeter 142 can be about a same width or length as the die 124. At least one side of the one or more walls 134 or the perimeter 142 of the one or more walls 134 can comprise a gap 148 (shown in FIG. 2) configured to allow the material 140 to be injected, deposited, inserted or the like into the KIZ 132 underneath the die 124. The material 140 inserted underneath the die 124 can be an underfill material configured to insulate or isolate the one or more connectors 122 or interconnects 114 from one or more other connectors or interconnects. The one or more barriers 128 can be configured to contain the material 140 within the KIZ 132 of the one or more barriers 128 and prevent the material 140 from flowing outside of the one or more barriers 128 into the KOZ 130. In some cases, the material 140 can at least partially, substantially, or fully cover a bottom surface 150 of the die 124. In some instances, the material 140 can at least partially, substantially, or fully be contained underneath the die 124.

Forming the one or more barriers 128 within the substrate 102 provides several advantages. The one or more barriers 128 can help enclose material 140 in tighter or smaller spaces, enabling co-packaging of the die 124 within the substrate 102 to improve or increase functionality. Additionally, the height of the one or more barriers 128 can be small (e.g., 20 micrometers to 50 micrometers), as discussed above, which means that the one or more barriers 128 do not consume a lot of area within the substrate 102.

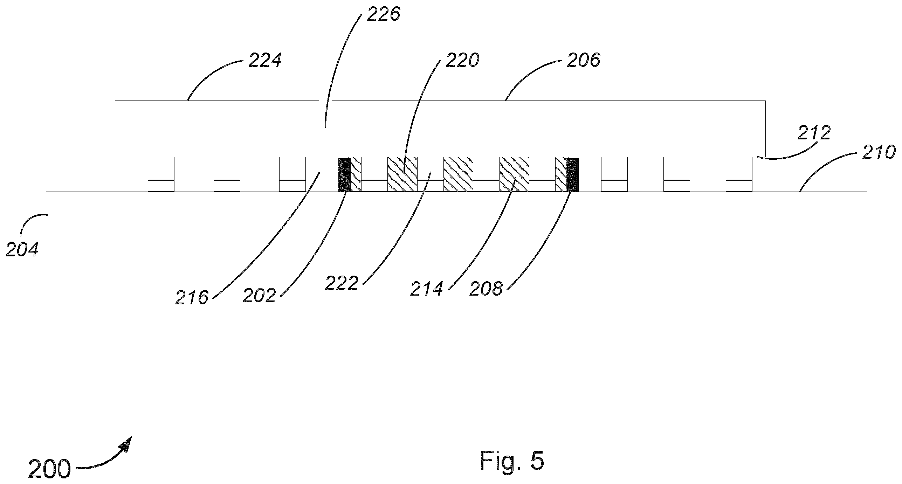

Turning to the embodiments shown in FIG. 5, a semiconductor device 200 can include one or more barriers 202 between a first substrate 204 and a second substrate 206. The one or more barriers 202 can have similar properties as the one or more barriers 128 described with respect to FIG. 1 and be formed from similar materials or using similar techniques.

The first substrate 204 or the second substrate 206 can be an interposer, a die or circuit, a circuit board (e.g., a printed circuit board), a packaging substrate, or other component, or the like. The first substrate 204 or the second substrate 206 can include a supporting material upon which or within which elements or components of semiconductor device 200 are fabricated or coupled. In various cases, the first substrate 204 or the second substrate 206 can be formed from one or more layers (not shown). The one or more layers can include, without limitation, one or more dielectric layers, one or more device layers, one or more conducting layers, one or more insulating layers, one or more redistribution layers, and/or the like.

In various cases, one or more walls 208 of the one or more barriers 202 can be formed on a first surface 210 of the first substrate or a second surface 212 of the second substrate 206. The first surface 210 or the second surface 212 can be one or more outer or external surfaces of the first substrate 204 or the second substrate 206. In various cases, the one or more barriers 202 can be used to form a KIZ 214 between the first substrate 204 and the second substrate 206 and a KOZ 216 between the first substrate 204 and the second substrate 206. At least one side of the one or more walls 208 can comprise a gap configured to allow a material 220 to be injected, deposited, inserted or the like into the KIZ 214 between the first substrate 204 and the second substrate 206. In various cases, the material 220 can be similar to the material 140 of FIGS. 1-4. In a non-limiting example, the material 220 inserted between the first substrate 204 and the second substrate 206 can be an underfill material configured to insulate or isolate one or more interconnects or connectors 222 from one or more other connectors or an adhesive material configured to couple the first substrate 204 to the second substrate 206. The one or more barriers 202 can be configured to contain the material 220 within the KIZ 214 of the one or more barriers 202 and prevent the material 220 from flowing outside of the one or more barriers 202 into the KOZ 216.

Forming the one or more barriers 202 using at least one of a jetting technique or extrusion technique between the first substrate 204 and the second substrate 206 provides several advantages. The one or more barriers 202 can help enclose material 220 in tighter spaces enabling coupling of the first substrate 204 to the second substrate 206 while also improving or increasing functionality of the first substrate 204 or the second substrate 206. In a non-limiting example, by containing the material 220 to a smaller space, an attachment area between the first substrate and the second substrate 206 can be smaller allowing more dies or other components of a semiconductor device 200 to be coupled to at least one of the first substrate 204 or the second substrate 206. In a non-limiting example, the one or more barriers 202 can be used to ensure that the material 220 does not expand or flow outside the area of the second substrate 206 coupled to the first substrate 204 such that an additional substrate or component 224 can be coupled directly adjacent to the second substrate 206 on the first substrate with a minimal gap 226 (e.g., about 5 to about 15 micrometers) between the second substrate and the additional substrate 224. Additionally, the height of the one or more barriers 202 can be small (e.g., 20 micrometers to 50 micrometers) which means that the one or more barriers 128 do not consume a lot of area between the first substrate 204 and the second substrate 206. This can increase the number of substrates or other components that can be stacked in a vertical direction within the semiconductor device 200.

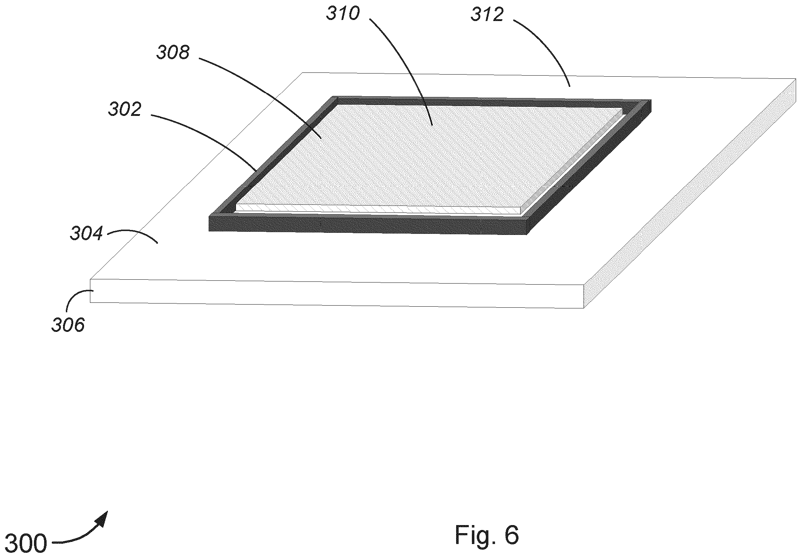

Turning to FIG. 6, a semiconductor device 300 can include one or more barriers 302 formed on a top surface 304 of a substrate 306. The one or more barriers 302 can have similar properties as the one or more barriers 128 or 202 described with respect to FIGS. 1-5 and be formed from similar materials or using similar techniques.

The first substrate 306 can be an interposer, a die or circuit, a circuit board, a packaging substrate, or other component of the semiconductor device 300, or the like. The first substrate 306 can include a supporting material upon which or within which elements or components of semiconductor device 300 are fabricated or coupled. In various cases, the first substrate 306 can be formed from one or more layers (not shown). The one or more layers can include, without limitation, one or more dielectric layers, one or more device layers, one or more conducting layers, one or more insulating layers, one or more redistribution layers, and/or the like

The one or more barriers 302 can be configured to contain one or more thermal interface materials 308 (shown by the patterned area between the barriers 302) to a defined area on the substrate 306. By providing one or more barriers 302 to contain the one or more thermal interface materials 308, the thermal interface material 308 can be contained within a KIZ 310 and prevented from flowing to a KOZ 312. In a non-limiting example, by forming the one or more barriers 302 on the top surface 304 of the substrate 306, the one or more thermal interface materials 308 can be confined to a specific area of the substrate 306 and be prevented from interfering with other components of the semiconductor device 300.

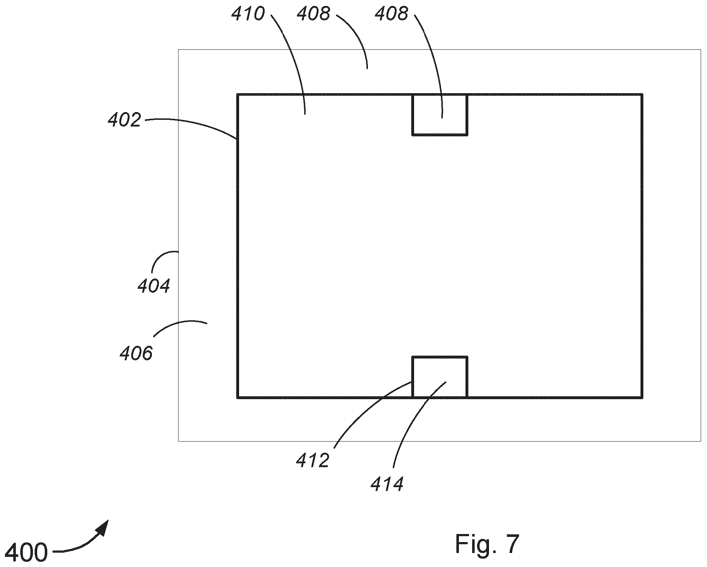

Turning to FIG. 7, a semiconductor device 400 can include one or more barriers 402 formed on a top surface 404 of a substrate 406. The one or more barriers 402 can have similar properties as the one or more barriers 128, 202, or 302 described with respect to FIGS. 1-6 and be formed from similar materials or using similar techniques.

The first substrate 406 can be an interposer, a die or circuit, a circuit board, a packaging substrate, or the like. The first substrate 406 can include a supporting material upon which or within which elements or components of semiconductor device 400 are fabricated or coupled. In various cases, the first substrate 406 can be formed from one or more layers (not shown). The one or more layers can include, without limitation, one or more dielectric layers, one or more device layers, one or more conducting layers, one or more insulating layers, one or more redistribution layers, and/or the like

The one or more barriers 402 can be configured to contain one or more materials (not shown) as described above with respect to FIGS. 1-6 within the KIZ 408 of the one or more barriers 402. In a non-limiting example, one or more walls 412 of the one or more barriers 402 can be used to outline one or more areas where the one or more materials are needed. By using barrier materials formed from one or more materials discussed above with respect to FIG. 1, or the like, and formation techniques such as applying pre-formed barriers, jetting, or extrusion techniques, smaller barriers 402 can be formed to surround small areas 414 (e.g., about 10 square-micrometers to about 30 square-micrometers). For example, as shown in FIG. 7, barriers 402 can be formed that outline the small area 414 to adhere a stiffener ring or other component to the substrate 406. The one or more materials can then be deposited within that small area 414. When the stiffener ring or other component is then attached to the small area 414, the barrier 402 can be used to prevent the one or more materials from squeezing or expanding from the KIZ 408 to the KOZ 410. In other words, the barrier 402 can prevent the one or more materials from expanding past the area of the stiffener ring or other component.

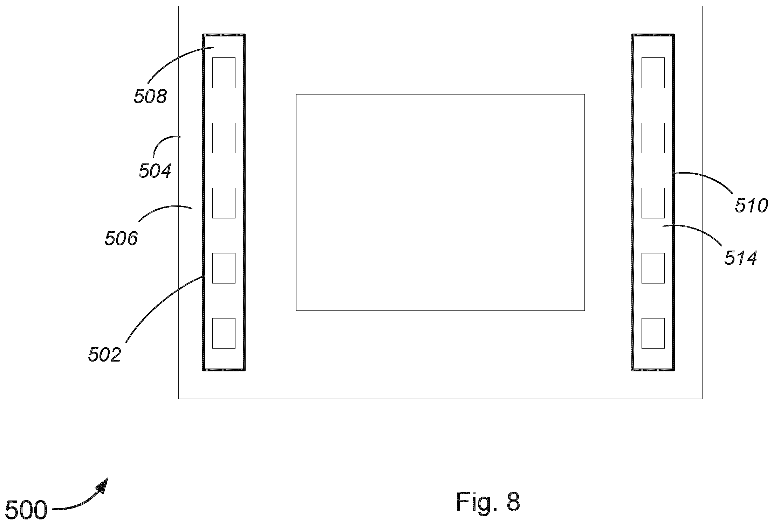

Turning to FIG. 8, a semiconductor device 500 can include one or more barriers 502 formed on a top surface 504 of a substrate 506. The one or more barriers 502 can have similar properties as the one or more barriers 128, 202, 302, or 402 described with respect to FIGS. 1-7 and be formed from similar materials or using similar techniques.

The substrate 506 can be an interposer, a die or circuit, a circuit board, a packaging substrate, or the like. The substrate 506 can include a supporting material upon which or within which elements or components of semiconductor device 500 are fabricated or coupled. In various cases, the first substrate 506 can be formed from one or more layers (not shown). The one or more layers can include, without limitation, one or more dielectric layers, one or more device layers, one or more conducting layers, one or more insulating layers, one or more redistribution layers, and/or the like.

The one or more barriers 502 can be configured to contain one or more materials, such as the materials described above with respect to FIGS. 1-7, within the KIZ 508 of the one or more barriers 502. In a non-limiting example, one or more walls 510 of the one or more barriers 502 can be used to outline one or more areas where the one or more materials are needed. In a non-limiting example, the one or more barriers 502 can be used to outline one or more connectors, capacitors, or other active or passive devices 512 coupled to the substrate 506. One or more materials can then be deposited within the one or more barriers 502 to prevent the one or more one or more connectors, capacitors, or other active or passive devices 512 from short circuiting one or more other connectors, capacitors, or other active or passive devices.

In some cases, the one or more barrier materials used to form the one or more barriers 502 can be used to fill the area 514 and incapsulate the one or more connectors, capacitors, or other active or passive devices 512. In other words, the one or more barrier materials used to form the one or more barriers 502 can be used to isolate the one or more connectors, capacitors, or other active or passive devices 512 from each other.

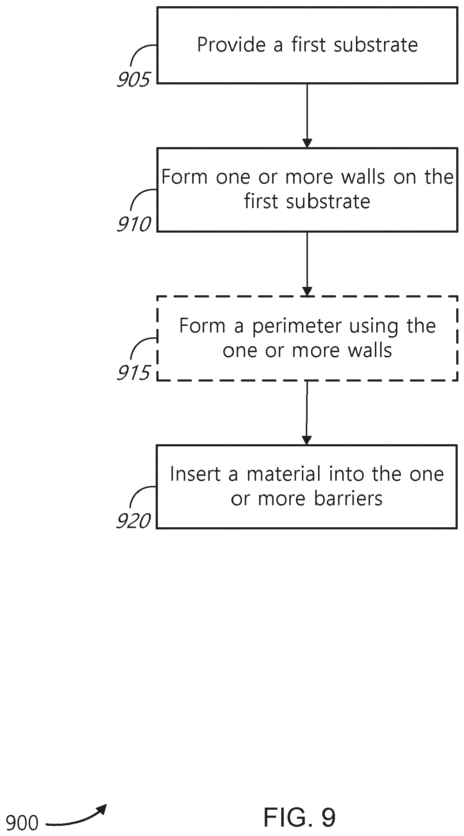

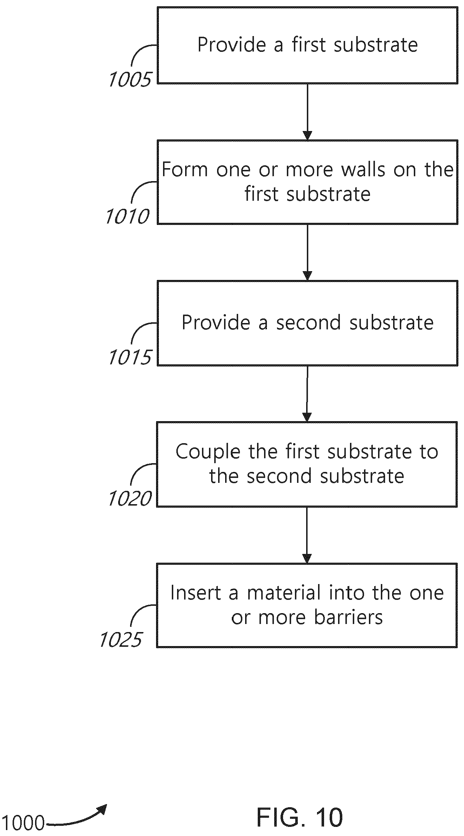

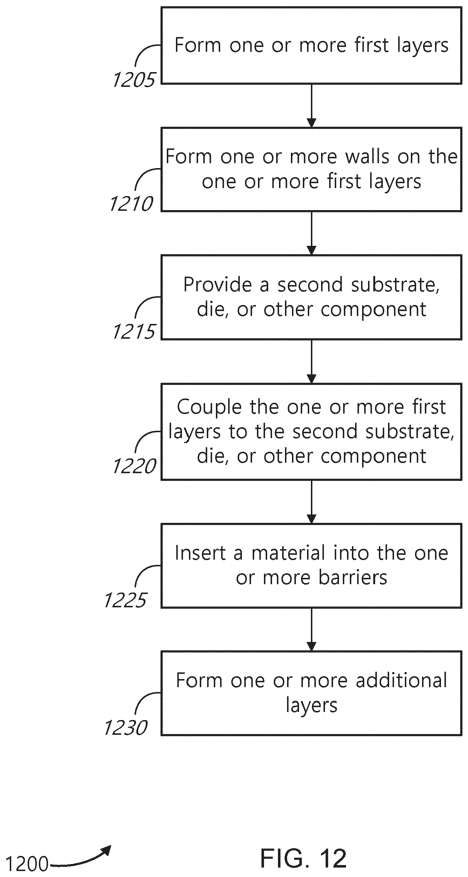

FIGS. 9, 10, and 12 are flow diagrams of a method of manufacturing a barrier (e.g., barriers 128, 202, 302, 402, or 502, or the like) for a semiconductor device (e.g., semiconductor device 100, 200, 300, 400, 500, or the like), in accordance with various embodiments. FIG. 9 is a flow diagram of a method of manufacturing the barrier formed on a first surface of a substrate. FIG. 10 is a flow diagram of a method of manufacturing the barrier formed between two substrates. Fig. 12 is a flow diagram of a method of manufacturing a barrier embedded within a substrate.

Turning to FIG. 9, the method 900 may begin, at block 905, by providing or forming a substrate (e.g., first substrate 102, first substrate 204, second substrate 206, first substrate 306, first substrate 406, or first substrate 506, or the like) or one or more layers (e.g., one or more first layers 104 or the like) of a first substrate. Forming the substrate or the one or more layers of the first substrate may include, without limitation, various additive and/or subtractive manufacturing processes, as known to those skilled in the art. In further examples, manufacturing techniques that are being developed and/or yet to be developed may be utilized to form the substrate. Thus, it is to be understood that the method 900 is not limited to any particular method of manufacturing the first substrate or one or more layers of the first substrate.

In some cases, method 900, at block 910 can further include forming one or more walls (e.g., walls 134, or the like) of the one or more barriers on a first surface of the substrate or a first surface of the one or more layers of the first substrate. In some cases, the first surface can be a first outer surface of the substrate or the one or more layers of the first substrate. The barrier can be formed using pre-formed barriers, jetting techniques, or extrusion techniques as described above with respect to FIG. 1. In order to form the one or more walls, one or more pre-formed barriers can be applied using pick-and-place tools or one or more layers of barrier material can be deposited or extruded (e.g., *in situ)* on the surface of the first substrate or the one or more first layers. In other words, the one or more walls can be formed by sequentially depositing one or more layers of barrier material on top of a preceding layer until a desired wall height is obtained. In various cases, the one or more barrier materials for the one or more walls 134 can then be cured using an ultra-violet light or heat as the one or more layers are deposited or after the one or more layers are deposited.

In some cases, the one or more walls can be used to form a perimeter at optional block 915. The perimeter can be used to form one or more KIZs or KOZs. In some cases, the KIZ could be contained within the perimeter of the one or more walls while the KOZ could be outside the perimeter of the one or more walls. In other cases, the KIZ could be outside the perimeter of the one or more walls and the KOZ could be within the perimeter of the one or more walls. Alternatively, the one or more walls can be used to form one or more KIZs or KOZs without forming a perimeter or a fully enclosed shape. In a non-limiting example, a first side of a wall could be a KIZ while a second side opposite the first side of the wall could be a KOZ.

Once the one or more barriers are formed, the method 700 can continue onto block 720 and comprise inserting, forming, injecting, coupling, or the like, a material into the KIZ of the one or more barriers. The material could include one or more of at least one of an underfill material, an adhesive material, or a thermal interface material, or other material. In various cases, the material could be used to couple one or more components of the semiconductor device to the first substrate, insulate one or more connectors or interconnects (e.g., solder balls, solder pads, pads, conductive film or coating, or other conductive elements or connectors, or the like) from each other on the first substrate, provide a thermal conducting material (e.g., to dissipate heat or the like) on the substrate, or provide other functions or features. In some cases, the barrier material itself could be inserted into KIZ and used to couple one or more components of the semiconductor device to the first substrate, insulate one or more connectors or interconnects (e.g., solder balls, solder pads, pads, conductive film or coating, or other conductive elements or connectors, or the like) from each other on the first substrate, provide a thermal conducting material (e.g., to dissipate heat or the like) on the substrate, or provide other functions or features.

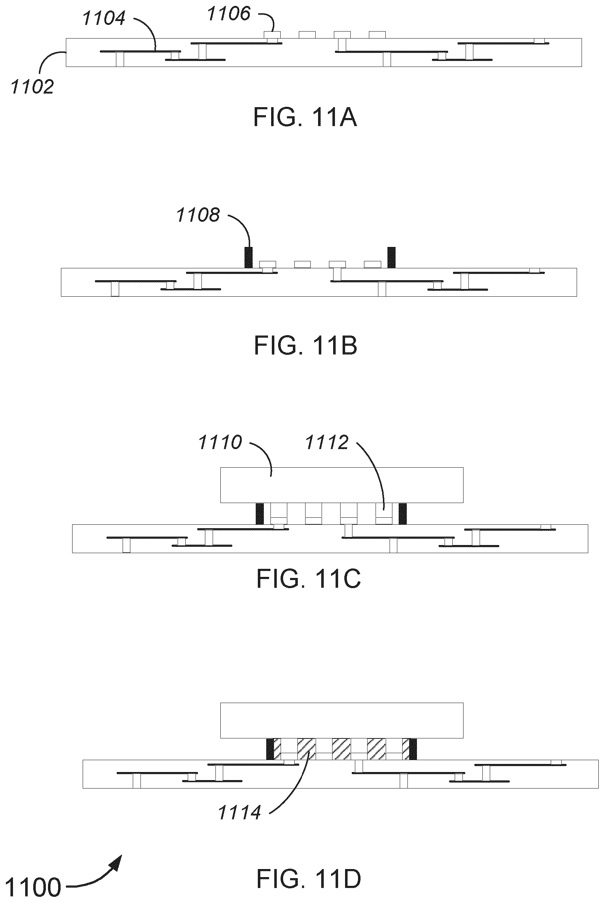

Turning to FIGS. 10 and 11, FIG. 10 is a flow diagram of a method of manufacturing the barrier formed between two substrates and FIG. 11 is a cross-sectional view of a semiconductor device 1100 formed using the steps of FIG. 10.

The method 1000 may begin, at block 1005, by providing or forming a first substrate (e.g., first substrate 1102 of FIG. 11 or the like). This step can be similar to step 905 of FIG. 9. In some cases, forming the first substrate can include forming one or more first interconnects (e.g., first interconnects 1104 or the like) within the first substrate or first connectors (e.g., first connectors 1106 or the like) on a first surface of the first substrate.

The method 1000 can further include forming one or more walls (e.g., walls 1108 or the like) of one or more barriers on a first surface of the substrate at block 1010. In some cases, the first surface can be a first outer surface of the substrate. This step can be similar to step 910 of FIG. 9.

Next, the method 1000 can continue, at block 1015, by providing or forming a second substrate (e.g., second substrate 1110 or the like). This step can be similar to step 905 of FIG. 9. In some cases, the second substrate can be formed independently or at a different time than the first substrate. Alternatively, the second substrate can be formed at about a same time as the first substrate. In some cases, forming the second substrate can include forming one or more second interconnects within the second substrate or second connectors (e.g., second connectors 1112 or the like) on a second surface of the second substrate.

The method can then include at block 1020, by coupling the first substrate to the second substrate via the first and second connectors. The one or more connectors between the first substrate and the second substrate could be directly connected or indirectly connected via a solder connection or a conductive film or the like.

Once the first substrate is coupled to the second substrate, the method 1000 can continue onto block 1025 and comprise inserting, forming, injecting, coupling, or the like, a material (e.g., material 1114 or the like) into a KIZ of the one or more barriers between the first substrate and the second substrate. This step could be similar to step 920 of FIG. 9. The one or more barriers can be configured to ensure that the material does is contained within the KIZ and does not flow or expand to a KOZ.

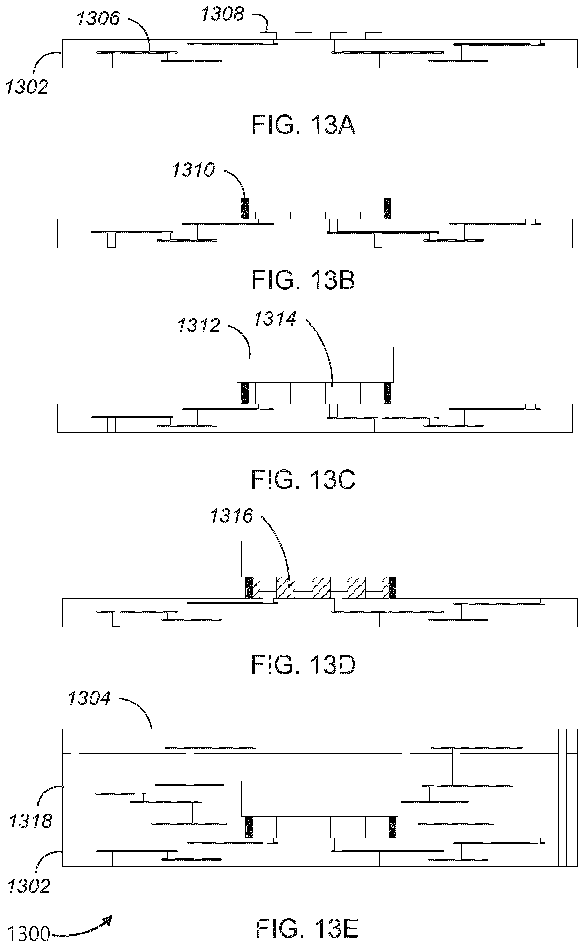

Turning to FIGS. 12 and 13, FIG. 12 is a flow diagram of a method 1200 of manufacturing the barrier embedded within a first substrate and FIG. 13 is a cross-sectional view of a semiconductor device 1300 formed using the steps of FIG. 12.

The method 1200 may begin, at block 1205, by providing or forming one or more first layers (e.g., one or more first layers 1302 of FIG. 13 or the like) of a first substrate (e.g., first substrate 1304 or the like). This step can be similar to step 905 of FIG. 9 or step 1005 of FIG. 10. In some cases, forming the one or more first layers of the first substrate can include forming one or more first interconnects (e.g., first interconnects 1306 or the like) within the first substrate or first connectors (e.g., first connectors 1308 or the like) on a first surface of the first substrate.

The method 1200 can further include forming one or more walls (e.g., walls 1310 or the like) of one or more barriers on a first surface of the one or more first layers of the first substrate at block 1210. In some cases, the first surface can be a first inner surface of the first substrate. This step can be similar to step 910 of FIG. 9.

Next, the method 1200 can continue, at block 1215, by providing or forming a second substrate, die, or other component (e.g., second substrate, die, or other component 1312 or the like). In some cases, the second substrate, die, or other component, can be formed independently or at a different time than the one or more first layers of the first substrate. Alternatively, the second substrate, die, or other component, can be formed at about a same time as the one or more first layers of the first substrate. In some cases, forming the second substrate, die, or other component, can include forming one or more second interconnects within the second substrate, die, or other component or second connectors (e.g., second connectors 1314 or the like) on a second surface of the second substrate, die, or other component.

The method can then include, at block 1220, by coupling the one or more first layers of the first substrate to the second substrate, die, or other component via the first and second connectors. The one or more connectors between the first substrate and the second substrate could be directly connected or indirectly connected via a solder connection or a conductive film or the like.

Once the one or more first layers of the first substrate are coupled to the second substrate, die, or other component, the method 1200 can continue onto block 1225 and comprise inserting, forming, injecting, coupling, or the like, a material (e.g., material 1316 or the like) into a KIZ of the one or more barriers between the one or more layers of the first substrate and the second substrate, die, or other component. This step could be similar to step 920 of FIG. 9. The one or more barriers can be configured to ensure that the material does is contained within the KIZ and does not flow or expand to a KOZ.

The method 1200 can then include the optional step, at optional block 1230, of forming one or more additional layers (e.g., additional layers 1318 or the like) onto the one or more first layers. The one or more additional layers could be used to at least partially, substantially, or fully encapsulate or embed the second substrate, die, or other component, the one or more walls of the one or more barriers, and the like within the first substrate.

The techniques and processes described above with respect to various embodiments may be used to manufacture the semiconductor devices 100-500 of FIGS. 1-8, and/or components thereof, as described herein.

While some features and aspects have been described with respect to the embodiments, one skilled in the art will recognize that numerous modifications are possible. For example, the methods and processes described herein may be implemented using hardware components, custom integrated circuits (ICs), programmable logic, and/or any combination thereof. Further, while various methods and processes described herein may be described with respect to particular structural and/or functional components for ease of description, methods provided by various embodiments are not limited to any particular structural and/or functional architecture but instead can be implemented in any suitable hardware configuration. Similarly, while some functionality is ascribed to one or more system components, unless the context dictates otherwise, this functionality can be distributed among various other system components in accordance with the several embodiments.

Moreover, while the procedures of the methods and processes described herein are described in a particular order for ease of description, unless the context dictates otherwise, various procedures may be reordered, added, and/or omitted in accordance with various embodiments. Moreover, the procedures described with respect to one method or process may be incorporated within other described methods or processes; likewise, system components described according to a particular structural architecture and/or with respect to one system may be organized in alternative structural architectures and/or incorporated within other described systems. Hence, while various embodiments are described with or without some features for ease of description and to illustrate aspects of those embodiments, the various components and/or features described herein with respect to a particular embodiment can be substituted, added and/or subtracted from among other described embodiments, unless the context dictates otherwise. Consequently, although several embodiments are described above, it will be appreciated that the invention is intended to cover all modifications and equivalents within the scope of the following claims.

## Claims

1. A semiconductor device comprising:
a first substrate comprising a first layer;
a wall coupled to a first surface of the first layer; and
a material coupled to the first surface of the first layer, wherein the wall is configured to block the material from flowing outside of the wall.

2. The semiconductor device of claim 1, wherein the wall comprises a perimeter formed using two or more layers of printed material or jetted material, and wherein the perimeter of the wall is configured to contain the material and to block the material from flowing outside of the wall.

3. The semiconductor device of claim 2, wherein the perimeter of the wall is at least one of circle-shaped, oval-shaped, triangle-shaped, square-shaped, or rectangular-shaped.

4. The semiconductor device of one of the previous claims, wherein a height of the wall is about 10 micrometers to 50 micrometers, and wherein a width of the of the wall is about 10 micrometers to 50 micrometers,
and/or
wherein the wall is formed from at least one of an oligomer, a polymer, an ink-based material, an emulsion-based material, or an inorganic material, or a combination of one or more the oligomer, the polymer, the ink-based material, the emulsion-based material, or the inorganic material into a sol, a gel, a pigment, a paste, or a solution.

5. The semiconductor device of one of the previous claims, further comprising:
a die coupled to the first surface of the first layer via a connector;
wherein the wall is located between the first surface of the first layer and a second surface of the die; and
wherein the material coupled to the first layer is located between the first surface of the first layer and the second surface of the die.

6. The semiconductor device of claim 5, wherein a first ratio of a first height of the wall to a first width of the wall is between about 1:2 and about 1:5
and/or
wherein the wall is formed from a conductive material and is configured to be coupled to a connector of at least one of the first substrate or the die.

7. The semiconductor device of claims 5 or 6, wherein the first substrate further comprises a second layer coupled to the first layer, and wherein the die is at least partially embedded within a second layer of the first substrate
and/or
wherein the wall comprises a perimeter formed using two or more layers of printed material or jetted material, and wherein the perimeter of the wall is located under an edge of the die and is configured to contain the material and to block the material from flowing outside of the wall.

8. The semiconductor device of one of claims 5 to 7, wherein a second ratio of a first height of the wall to a second height of the first substrate is between about 1:5 and about 1:2.

9. The semiconductor device of one of the previous claims, further comprising:
a second substrate coupled to the first surface of the first layer via a connector;
wherein the wall is located between the first surface of the first layer and a second surface of the second substrate; and
wherein the material coupled to the first layer is located between the first surface of the first layer and a third surface of the second substrate.

10. The semiconductor device of claim 9, wherein the wall comprises a perimeter, and wherein the perimeter of the wall is configured to contain the material and to block the material from flowing outside of the wall
and/or
wherein the wall is formed from at least one of two or more layers of a printed material or two or more layers of a jetted material.

11. A method of manufacturing one or more walls configured to block flow of material from a selected location, the method comprising:
forming a first layer of a first substrate;
forming a wall on a first surface of the first substrate; and
coupling a material to the first surface of the first substrate, wherein the wall is configured to block the material from flowing outside of the wall.

12. The method of claim **11,** wherein the wall is formed using at least one of extrusion or jetting to form two or more layers, wherein the wall is formed from at least one of an oligomer, a polymer, or an inorganic material, or a combination of one or more the oligomer, the polymer, or the inorganic material into a sol, a gel, a pigment, a paste, or a solution.

13. The method of claims **11** or 12, wherein forming the first layer comprises forming an interconnect in the first layer, wherein the method further comprises:
coupling a die to the first surface of the first substrate, wherein a connector of the die is connected to the interconnect; and
wherein coupling a material to the first surface of the first substrate comprises inserting the material between the die and the first surface to surround the connector.

14. The method of claim 13, wherein the wall comprises a perimeter and wherein an internal area of the perimeter of the wall is configured to contain the material within the internal area of the perimeter of the wall,
in particular,
the method further comprising: forming a second layer on the first surface of the first substrate, wherein the die, wall, and material are at least partially embedded within the second layer.

15. A system comprising:
a first substrate comprising a first layer;
a wall coupled to a first surface of the first layer;
a material coupled to the first surface of the first layer, wherein the wall is configured to block the material from flowing outside of the wall; and
a die or a second substrate coupled to the first layer, wherein the wall and material are located between the first surface of the first layer and a second surface of the die or second substrate.
